# EUROPEAN PATENT SPECIFICATION

(11) **EP 0 332 411 B1**
(45) Date of publication and mention of the grant of the patent: **25.05.1994**
(21) Application number: 89302288.9
(22) Date of filing: 07.03.1989
(51) Int. Cl.: H01G 1/035

(54) **Chip type capacitor and manufacturing thereof**
Chipkondensator und Verfahren zur Herstellung
Condensateur du type puce et son procédé de fabrication

(30) Priority: 07.03.1988 JP 54599/88; 29.06.1988 JP 161431/88; 11.08.1988 JP 200383/88; 07.11.1988 JP 280864/88
(43) Date of publication of application: 13.09.1989
(73) Proprietor: NIPPON CHEMI-CON CORPORATION, Ome-shi Tokyo (JP)
(72) Inventor: Ando, Susumu, Ome-Shi Tokyo 198 (JP); Hagiwara, Ikuo, Ome-Shi Tokyo 198 (JP)
(74) Representative: Cook, Anthony John

(56) References cited:
- EP-A- 0 139 431
- FR-A- 1 566 728
- JP-A-60 245 116
- US-A- 3 778 532

## Description

This invention relates to an improved chip type capacitor particularly suitable for mounting on a surface of a printed circuit board.

Hitherto, a capacitor in chip form has been realised in a manner wherein a capacitor element is first accommodated in a sheathing case of synthetic resin for subjection to a molding operation and then terminals extending from an end of the resin to provide an exterior connection are bent along the end of the resin to match with the wiring pattern of the printed circuit board.

Further, it has been proposed to accommodate a conventional capacitor in a sheathing frame for arrangement of the terminals in the same plane as the end of the sheathing frame as disclosed in the Japanese Utility Model Publication 59-3557. Another proposal is to arrange a capacitor in a closed-end cylindrical sheathing frame with the terminals extending from through-holes on the top surface of the sheathing frame and being bent into in a concave section provided on the external surface of the sheathing frame as disclosed in the Japanese laid-open patent publication 60-245116 and the Japanese laid-open patent publication 60-24511.

These conventional capacitors are available for a surface mounting without changing the normal structure of the capacitor.

However, in a conventional chip type capacitor made using a mold processing operation, capacitor elements are likely to suffer a heat deterioration due to a thermal stress during the mold processing.

Moreover, in a case (illustrated in Figure 9 herein) where a capacitor is received in a sheathing frame 2 from an end of which terminals 3, 3 are derived for connection into a printed circuit board 12 for preparing a chip type capacitor with a soldering 13, only one end of the chip type capacitor is fixed to the printed circuit board 12, so that an opposite end thereof is separated upwardly from the surface of the printed circuit board owing to the soldering heat. Such a capacitor mounting suffers the disadvantage that the capacitor may be peeled off the printed circuit board 12 by a mechanical stress.

Furthermore, because of the progress of miniaturization of the electronic parts, the space between terminals of electronic parts becomes extremely small in dimension. Moreover, with miniaturisation, the wiring pattern density of the printed circuit board is increased and efficient arrangement requires various distances between the terminals. Thus, it is required to hold terminals so as to cope with various minimum distances between terminals by keeping a proper distance between terminals or avoid a short-circuit being caused by soldering.

Further, a tip end of the terminal exposed to a top surface of the sheathing frame is liable to return its original shape on account of a warp caused by a so-called elasticity. This makes it difficult to hold a proper position and distance.

Also, when a capacitor is received in a sheathing frame made of heat-resistive resins and the like, to achieve a satisfactory high speed molding of the sheathing frame is very difficult.

Further, in the process of accommodating the capacitor in the sheathing frame, the capacitor is received in the sheathing frame formed by a mold, so that individual sheathing frames are required to be aligned by the parts feeder or equivalent device. Thus, capacitor insertion in the frame is complex. There is difficulty in accelerating the manufacturing process and a requirement for high accuracy of the jig and the like for the accommodating operation. A different jig or process is required if a reverse-mounting or different mounting of the capacitor is desired.

An aim of the present invention is to provide a chip type capacitor which is easy to mount as desired onto a printed circuit board without altering the structure of the conventional capacitor.

Another aim of the invention is to manufacture a chip type capacitor more efficiently and at a higher speed than conventionally used.

According to a first aspect of the present invention, there is provided a chip type capacitor comprising: a capacitor having lead wires projecting from a terminal end thereof; and a sheathing frame having a cavity compatible with the external shape of the capacitor, which is accommodated in the cavity with the lead wires projecting out of a first end of the cavity and bending round to lie in grooves in a top surface of the sheathing frame; characterized in that: the top surface of the sheathing frame is partially provided with a solderable metal layer for fixing the chip type capacitor to a circuit board, the solderable metal layer being spaced from the lead wires; and the first end of the cavity of the sheathing frame is partially closed by a member which defines an aperture through which the lead wires project before bending round to lie in the grooves.

According to a second aspect of the present invention, there is provided a process for manufacturing a chip type capacitor according to the first aspect of the present invention, wherein the sheathing frame is connected to a portion which projects from a strip substrate so that opposed extensions of the portion are buried in the top surface of the sheathing frame, and then the portion is separated from the strip substrate to function as the solderable metal plate.

Other advantages of the invention will be appreciated from the following description.

Preferred embodiments of the chip type capacitor according to the invention and a manufacturing method thereof are described below in detail with reference to the accompanying illustrative drawings in which:-
Figure 1 is a perspective view showing one embodiment of the chip type capacitor according to the invention;
Figure 2 is a perspective view showing another embodiment of the chip type capacitor according to the invention;
Figure 3 is a side view showing a further embodiment of the chip type capacitor according to the invention;
Figure 4 is a perspective view showing still a further embodiment of the chip type capacitor according to the invention;
Figure 5 is a perspective view of the manufacturing process descriptive of the chip type capacitor as shown in Figure 4;
Figure 6 is a perspective view showing another more embodiment of the chip type capacitor according to the invention; and
Figures 7 and 8 are elevations of the manufacturing process illustrative of the chip type capacitor as shown in Figure 6.

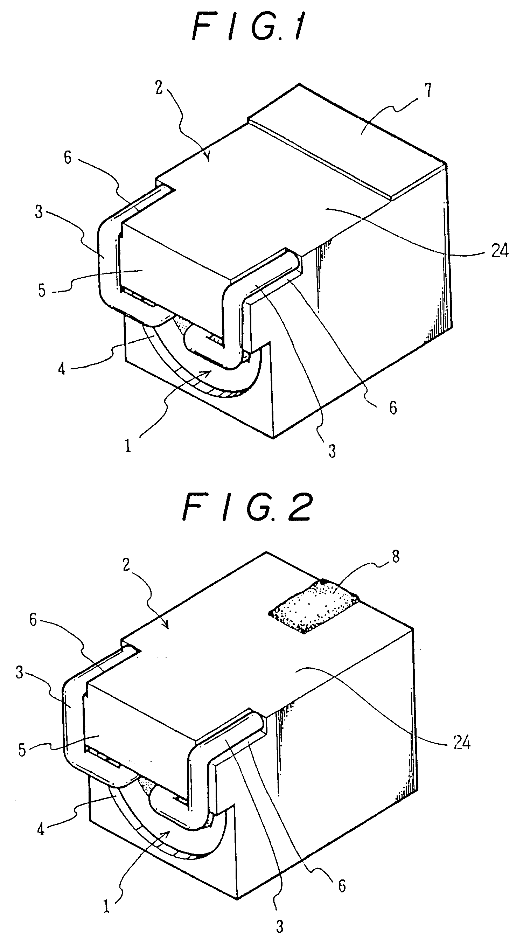

In Figure 1, the capacitor body 1 is formed of a capacitor element of an electrode foil with an electrolytic paper wound together (not shown) and accommodated in a cylindrical sheathing frame having a closed end and made of aluminum and the like and an opened end of the sheathing frame is closed by a sealing member. Terminals 3, 3 derived from the capacitor element are led out through the sealing member.

The capacitor body 1 is received in the sheathing frame 2 having a cylindrical space 4 compatible with an external size and shape of the capacitor 1. The sheathing frame 2 is desirably formed of an excellent heat resistive material, preferably such heat resistive synthetic resins as epoxy, phenol, polyimide or ceramics and the like.

In this embodiment, the space 4 of the sheathing frame 2 is formed into a cylindrical shape of an internal size substantially the same as an external size of the capacitor 1. However, when the capacitor of non-cylindrical shape, for example, the capacitor having an ellipsoid section is used, the sheathing frame 2 having an ellipe cylindrical space 4 compatible with the configuration of the capacitor may preferably be used.

The terminals 3, 3 derived from an end of the capacitor 1 are bent along an opened end of the sheathing frame 2 and the top surface 24 for reception into grooves 6, 6 provided in the top surface 24 of the sheathing frame 2. In the top surface 24 of the sheathing frame 2 is previously arranged a metal piece 7 at a position not contacting the terminals 3, 3. The metal piece 7 may be arranged in the top surface 24 of the sheathing frame 2 by means of binding or mounting, notwithstanding in this embodiment a bonding agent is applied to a predetermined position before the metal piece 7 is bound thereto. Further, since the metal piece 7 when mounted on the printed circuit board is fixed by soldering, the solderable metals such as silver, tin, lead, zinc, nickel, iron, copper or alloys thereof are preferably selected. Alternatively, a metal tape in which a bonding agent is applied to one side of a solderable thin metal piece may be employed.

The opened end of the sheathing frame 2 is provided with a member (e.g. protuberance 5) for covering a part of the opened end in contact with a terminal face of the capacitor 1 accommodated in the receiving space 4 of the sheathing frame 2. Consequently, the capacitor body 1 is held fixed in the sheathing frame 2 by the protuberance 5 and the bent terminals 3, 3.

In Figure 1, terminals 3, 3 extending from a capacitor 1 and a soldable metal layer 7 are arranged in a top surface 24 of the sheathing frame 2. When the chip type capacitor is substantially mounted on a printed circuit board, terminals 3, 3 and the metal piece 7 are respectively soldered so that opposite ends of the top surface of the chip type capacitor are seated and fixed on the printed circuit board.

In this embodiment, in the top surface 24 (Fig. 1) of the sheathing frame 2 are arranged the terminals 3, 3 which extend from the capacitor body 1 and the previously bonded metal piece 7. When the chip type capacitor according to this embodiment is mounted on a printed circuit board, opposite ends of the chip type capacitor are fixed on the printed circuit board by soldering the terminals 3, 3 and the metal piece 7 respectively to the board.

In Figure 2, the second embodiment according to the invention is shown, in which the capacitor body 1 is provided with the terminals 3, 3 extending from an end of the sealing member like the first embodiment. The sheathing frame 2 is provided with the receiving space 4 to accommodate the capacitor body as well as the protuberance 5 to cover a part of the opened end similar to the first embodiment. The terminals 3, 3 are bent along an end of the capacitor 1 and the top surface of the sheathing frame 2 for exposure onto the top surface 24 of the sheathing frame 2 to which a conductive paste 8 is applied.

The conductive paste 8 is preferably prepared by mixing a metal powder of solderable metals such as silver, tin, lead, zinc, nickel, iron, copper and the like or their mixtures or alloys into synthetic resins. These resins are preferably thermosetting synthetic resins of excellent heat-resistive properties, such as epoxy, phenal, di-acryl phthalate, unsaturated polyesters, polymide, poly-amide bismaleimide and the like.

The chip type capacitor according to this embodiment is mounted on the printed circuit board like the first embodiment before terminals 3, 3 and the conductive paste 8 are respectively soldered.

In this embodiment, the solderable metal layer may be formed on the top surface 24 of the sheathing frame 2 by merely applying the conductive paste 8 to the top surface 24 of the sheathing frame 2 by any convenient process which forms the metal layer. Hence one avoids heat fluctuation, or peeling-off of the bonding agent caused by the heat of the soldering process of the first embodiment.

Moreover, since a thinner metal layer may be formed as compared with the first embodiment wherein the metal piece 7 is bound, the chip type capacitor may be stably mounted on the printed circuit board.

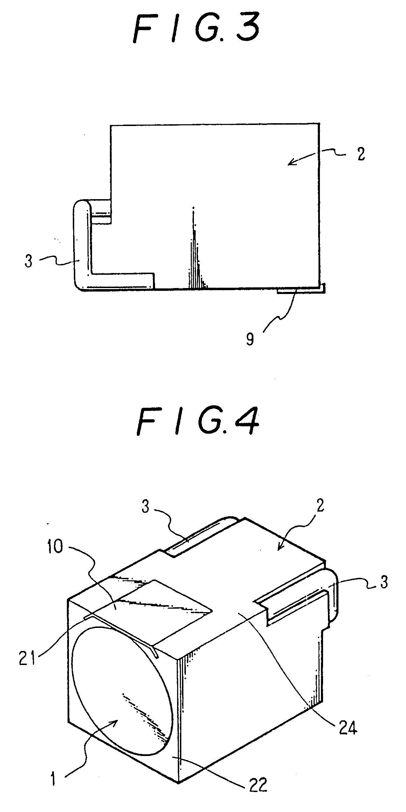

Furthermore, the third embodiment according to the invention is shown in Figure 3. In this embodiment, like the first and second embodiments, the capacitor body 1 having the terminals 3, 3 protruded from the end thereof is accommodated in the sheathing frame 2 and the terminals 3, 3 are bent along the opened end of the sheathing frame 2 and the top surface of the body.

The sheathing frame 2 from its top surface to the opened end is partially provided with a metal layer 9 of solderable metal such as silver, tin, zinc, nickel, iron, copper and the like by means of an evaporation or a non-electrolytic plating at a position not contacting the terminals 3, 3.

Since the chip type capacitor according to this embodiment dispenses with the processes of binding the metal piece 7 with bonding agents or coating the conductive paste 8 of synthetic resin mixed with metal like the second embodiment, the metal layer 9 may be formed in the sheathing frame 2 without consideration of the heat-resistive properties of the bonding agent and the synthetic resins with an enhanced reliability.

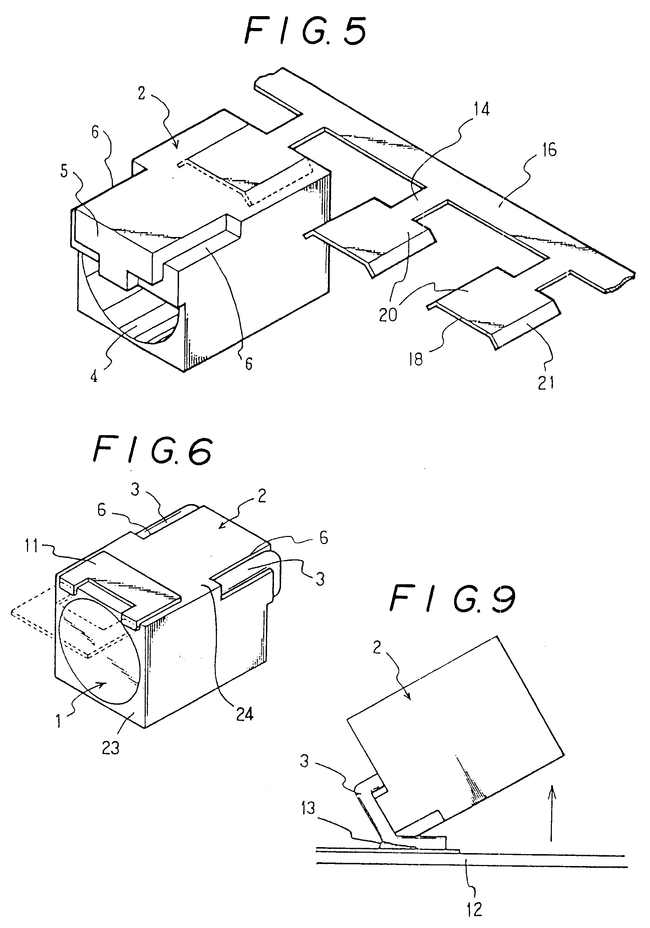

In Figures 4 and 5, the sheathing frame 2 is formed with the receiving space 4 for reception of the capacitor body 1 and one opened end thereof is provided with a projection 5 to cover a part of the opened end.

As shown in Figure 4, the capacitor 1 is received in the receiving space 4 of the sheathing frame 2 and the terminals 3, 3 of the capacitor 1 are bent along a projection 5 and the top surface 24 of the sheathing frame 2.

To the top surface 24 in the vicinity of an opposite opened end 22 confronting to the opened end formed with the projection 5 of the sheathing frame 2 is provided a metal plate 10 having the extensions 21. The extensions 21 are buried in the sheathing frame 2. The metal plate 10 may be formed of solderable metals such as silver, tin, lead, zinc, nickel, iron, copper or their alloys. Other metals may be suitable.

In the chip type capacitor according to this embodiment, the top surface 24 of the sheathing frame 2 is partially buried by the solderable metal plate 10, so that the metal plate 10 together with the terminals 3, 3 of the capacitor 1 may be soldered when the chip type capacitor is mounted on the printed circuit board.

As shown in Figure 5, the sheathing frame 2 used for the chip type capacitor of Figure 4 is connected to a comb-shaped lead frame 14 of a strip substrate 16 from which extend at predetermined distances portions 18, 18 having a flat section 20 and extensions 21.

In the manufacturing process according to the embodiment shown in Figure 5, the sheathing frame 2 is integrally formed with the connection portion 18 of the lead frame 14 so that a collective unit of the sheathing frame 2 linked by the lead frame 14 is provided for enabling a continuous manufacture of the sheathing frame 2. Further, since the collective body of the sheathing frame 2 and the lead frame 14 may be supplied together to the next process, the directions of the sheathing frames 2 to be supplied as a collective unit may be consolidated.

The lead frame 14 is formed of metal materials such as aluminium, iron, copper and the like or their clad materials and can be continuously supplied from a reel and the like.

The sheathing frame 2 is formed by burying the extensions 21, 21 of the connection 18 of the lead frame 14 into the top surface 24 of the sheathing frame. Any forming means may be used for this. That is, the connection 18 of the lead frame 14 is partially covered with a mold for injection of synthetic resin so that the extensions 21, 21 of the connection 18 are buried in the sheathing frame 2. Alternatively, an insertion process may be employed.

Further, after continuous formation of the sheathing frame 2 by connection with the lead frame 14, the connection 18 of the lead frame 14 is separated from the substrate 16. Thus, the flat portion 20 of the connection 18 of the lead frame 14 is exposed on the top surface of the sheathing frame 2 for binding to provide a metal plate 10 as shown in Figure 4.

Moreover, the capacitor body 1 is received in the sheathing frame 2 separated from the lead frame 14, and the terminals 3, 3 of the capacitor 1 are bent along the opened end of the sheathing frame 2 to the top surface 24 to obtain a chip type capacitor as shown in Figure 4.

In the manufacturing process of the chip type capacitor according to the embodiment, the sheathing frames 2 are linked by the lead frame 14 to provide a collective unit of the sheathing frames 2 for facilitating a continuous manufacturing or supply of even the fine sheathing frame 2.

In Figures 6 to 8, the sheathing frame 2 for receiving the capacitor 1 is formed with an accommodation space therein and one opened end thereof is provided with a projection for partially covering said opened end like the foregoing embodiments. The terminals 3, 3 of the capacitor 1 received in the sheathing frame 2 are bent along the opened end to the top surface 24 thereof for reception into the grooves 6, 6.

Further, in an opposite opened end 23 confronting to the opened end formed with the projection is fixed with a metal plate by burying a part thereof into the opened end 23. The metal plate 11 is made of solderable metals and bent along the opened end 23 of the sheathing frame 2 to the top surface 24.

In the chip type capacitor of the embodiments, at opposite ends of the sheathing frame 2 are arranged solderable metals including the terminals of the capacitor 1 at one end and the solderable metal plate 11 at opposite end. Soldering of opposite ends when the chip type capacitor is actually mounted on the printed circuit board ensures a tight attachment of the capacitor onto the printed circuit board.

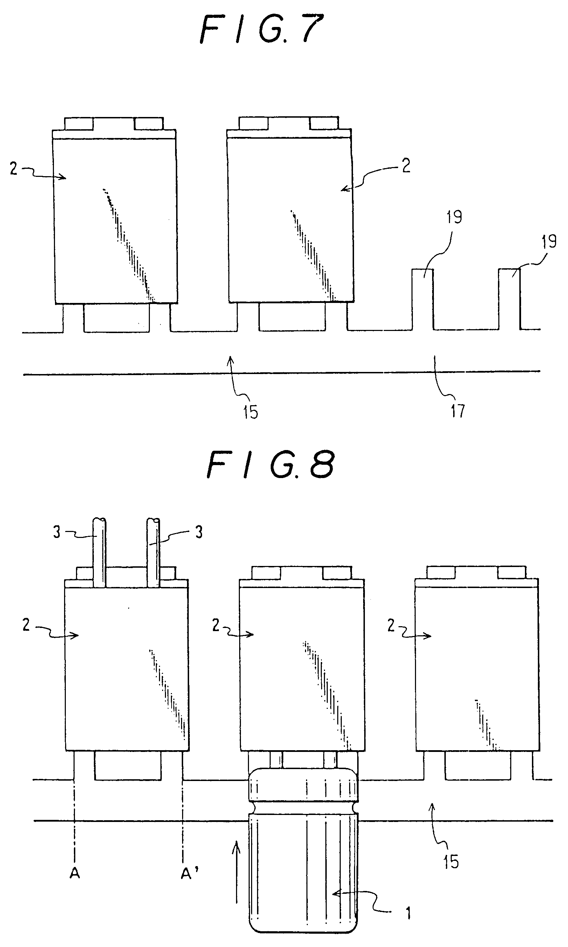

The chip type capacitor according to this embodiment may be manufactured by the process as shown in Figures 7 and 8. Namely, as may be seen in Figure 7, to the comb-shaped lead frame 15 in which the connecting portions 19 are projected from the strip substrate 17 at predetermined distances is associated the sheathing frame 2 by burying the connection 19 of the lead frame 15 into the opened end 23 with an insertion molding process. Namely, the connecting portion 19 of the lead frame 15 is partially covered by a mold for injecting the synthetic resin so that a tip end of the connection 19 is buried in the opened end 23 of the sheathing frame 2.

Furthermore, after the continuous formation of the sheathing frame 2 onto the lead frame 15, a collective unit of the sheathing frames 2 associated with the lead frame 15 are transferred together without separation of each sheathing frame as shown in Figure 8 and supplied to the receiving process of the sheathing frame 2 into the receiving space.

To individual sheathing frame 2 supplied as a collective unit is sequentially received the capacitor as shown in Figure 8. In this operation, since the directions of the sheathing frame 2 are all consolidated, the directions of the capacitors 1 to be received in the sheathing frame 2 or polarites of the terminals 3, 3 are controlled at constant to avoid the reverse-mounting of the capacitor 1.

Then the lead frame 15 is cut off along the dotted lines A-A as shown in Figure 8 to separate the sheathing frame 2 from the lead frame 15. Further, a part of the lead frame 15 remained in an independent sheathing frame 2 is bent along the opened end 23 and the top surface of the sheathing frame 2 for connection into the top surface 23 of the sheathing frame 2 as shown in Figure 6.

On the other hand, the terminals 3, 3 extended from the other opened end of the sheathing frame 2 is bent along the opened end and the top surface 24 of the sheathing frame 2 for reception into the grooves 6, 6 of the sheathing frame 2 to obtain the chip type capacitor.

In this embodiment, the bending process of the terminal 3, 3 is performed after separation of the sheathing frame 2 from the lead frame 15, notwithstanding the bending process before separation of the sheathing frame 2 from the lead frame 15 is available. In this case, a plurality of the capacitors may be subjected to the simultaneous bending processes of the terminals 3, 3 for realization of more efficient manufacturing process.

As hereinbefore fully described, with the embodiments of the present invention, the capacitor is received in the sheathing frame having the receiving space compatible with the external size of the capacitor, the terminals derived from the same opened end of the capacitor are bent along the opened end and the top surface of the sheathing frame and that the solderable metal layer is arranged in a part of the top surface thereof. With such an arrangement, when the terminals connected to the printed circuit board as well as the metal layer are soldered, as the chip type capacitor is fixed to the printed circuit board at opposite ends of the top surface of the sheathing frame, then any lifting up or separation of the chip type capacitor from a printed circuit board upon which it is mounted, such as may be caused by vibration, soldering heat, warping of the terminals and the like can be avoided. Also, the durability to the mechanical stress when the chip type capacitor is actually mounted on the printed circuit board is enhanced by these mounting conditions, giving increased reliability.

In an alternative process, the solderable conductive paste is applied to the top surface not contacting the terminals and a part of the opened end thereof, the solderable metal piece is bound or the solderable metal layer is formed by means of an evaporation or a non-electrolytic plating, so that an extremely thin solderable metal layer is formed on a part of the top surface of the sheathing frame. Thus, the good mounting condition of the chip type capacitor disclosed herein may be maintained without spoiling any stability thereof.

In another process, the solderable metal plate partially having extensions is mounted on the top surface of the sheathing frame by burying the extensions thereinto or the extensions of the metal plate are buried in the opened end of the sheathing frame while the metal plate is bent along the top surface of the sheathing frame, dispensing with binding of the metal piece. Hence, the capacitor at its opposite ends may be soldered without consideration of the heat fluctuation to be caused by a bonding agent and the like.

In a manufacturing process of a capacitor according to the invention, a portion projecting from a strip substrate is connected to the sheathing frame so that opposed extensions of the portion are buried in the top surface of the sheathing frame and then the portion is separated from the strip substrate to function as the solderable metal plate. This permits continuous production.

Further, since the metal plate is integral with the end of the sheathing frame, a tight connection is obtained with an enhanced reliability.

Preferably, the capacitor is inserted into the receiving space of the sheathing frame before the portion is separated from the strip substrate, so that the capacitor body may be continuously received in the sheathing frame free of parts feeder. Hence, a positive transfer of the sheathing frame ready to receive the capacitor body can be made at a higher speed.

In the receiving process of the capacitor body into the sheathing frame, individual sheathing frames linked by the lead frame as a collective unit are supplied in the same direction. Thus, when the capacitor is received in the sheathing frame, the directions of the terminals of the capacitor or polarities thereof are controlled to avoid the reverse-mounting of the capacitor to the sheathing frame with a simplified process but an enhanced reliability.

Although the invention has been described hereinabove in its preferred embodiments, many variations and modifications may be made, without departing from the invention as defined by the claims.

## Claims

1. A chip type capacitor comprising:
a capacitor (1) having lead wires (3) projecting from a terminal end thereof; and
a sheathing frame (2) having a cavity (4) compatible with the external shape of the capacitor (1), which is accommodated in the cavity (4) with the lead wires (3) projecting out of a first end of the cavity and bending round to lie in grooves (6) in a top surface (24) of the sheathing frame;
characterized in that:
the top surface (24) of the sheathing frame (2) is partially provided with a solderable metal layer (7, 8, 9, 10, 11) for fixing the chip type capacitor to a circuit board, the solderable metal layer being spaced from the lead wires (3); and
the first end of the cavity (4) of the sheathing frame (2) is partially closed by a member (5) which defines an aperture through which the lead wires (3) project before bending round to lie in the grooves (6).

2. A chip type capacitor according to claim 1, wherein the lead wires (3) extend from a first end of the top surface (24) of the sheathing frame (2) towards an opposite, second end of the top surface, and the solderable metal layer (7, 8, 9, 10, 11) is spaced from the first end of the top surface.

3. A chip type capacitor according to claim 2, wherein the solderable metal layer (7, 8, 9, 10, 11) is disposed at the second end of the top surface (24) of the sheathing frame (2).

4. A chip type capacitor according to claim 2 or 3, wherein the solderable metal layer (7, 8, 9, 10, 11) is disposed beyond the free ends of the lead wires (3).

5. A chip type capacitor according to any one of claims 1 to 4, wherein the solderable metal layer is a solderable metal piece (7), a solderable conductive paste (8), a solderable metal layer (9) applied by evaporation or non-electrolytic plating, or a solderable metal plate (10) provided with extensions (21) which are buried to bind the plate (10) in the material of the sheathing frame (2).

6. A process for manufacturing a chip type capacitor according to claim 5, wherein the sheathing frame (2) is connected to a portion (18) which projects from a strip substrate (16) so that opposed extensions (21) of the portion (18) are buried in the top surface (24) of the sheathing frame, and then the portion (18) is separated from the strip substrate (16) to function as the solderable metal plate (10).

7. A process according to claim 6, wherein the capacitor (1) is inserted into the cavity (4) of the sheathing frame (2) before the portion (18) is separated from the strip substrate (16).

## Patentansprüche

1. Ein Chipkondensator, der folgendes umfaßt:
einen Kondensator (1) mit Anschlußdrähten (3), die von einem Anschlußende desselben hervorstehen; und
einen Hüllrahmen (2) mit einem Hohlraum (4), der zu der äußeren Form des Kondensators (1) kompatibel ist, der in dem Hohlraum (4) aufgenommen ist, wobei die Anschlußdrähte (3) aus einem ersten Ende des Hohlraums hervorstehen und herumgebogen sind, um in Nuten (6) in einer obersten Oberfläche (24) des Hüllrahmens zu liegen;
dadurch **gekennzeichnet,** daß:
die oberste Oberfläche (24) des Hüllrahmens (2) teilweise mit einer lötbaren Metallschicht (7, 8, 9, 10, 11) versehen ist, um den Chipkondensator auf einer Leiterplatte zu befestigen, wobei die lötbare Metallschicht von den Anschlußdrähten (3) beabstandet ist; und
das erste Ende des Hohlraums (4) des Hüllrahmens (2) teilweise durch ein Element (5) geschlossen ist, das eine Öffnung festlegt, durch die die Anschlußdrähte (3) hervorstehen, bevor sie herumgebogen sind, um in den Nuten (6) zu liegen.

2. Ein Chipkondensator nach Anspruch 1, dadurch gekennzeichnet, daß sich die Anschlußdrähte (3) von einem ersten Ende der obersten Oberfläche (24) des Hüllrahmens (2) zu einem gegenüberliegenden, zweiten Ende der obersten Oberfläche erstrecken, und daß die lötbare Metallschicht (7, 8, 9, 10, 11) vom ersten Ende der obersten Oberfläche beabstandet ist.

3. Ein Chipkondensator nach Anspruch 2, dadurch gekennzeichnet, daß die lötbare Metallschicht (7, 8, 9, 10, 11) an dem zweiten Ende der obersten Oberfläche (24) des Hüllrahmens (2) angebracht ist.

4. Ein Chipkondensator nach Anspruch 2 oder 3, dadurch gekennzeichnet, daß die lötbare Metallschicht (7, 8, 9, 10, 11) unterhalb der freien Enden der Anschlußdrähte (3) angebracht ist.

5. Ein Chipkondensator nach einem der Ansprüche 1 bis 4, dadurch gekennzeichnet, daß die lötbare Metallschicht aus einem lotbaren Metallstück (7), einer leitfähigen Lötpaste (8), einer lötbaren Metallschicht (9), die durch Aufdampfen oder nicht-elektrolytischen Metallauflage aufgebracht wird, oder einer lötbaren Metallplatte (10) besteht, die mit Verlängerungen (21) versehen ist, die vertieft sind, um die Platte (10) im Werkstoff des Hüllrahmens (2) zu binden.

6. Ein Verfahren zur Herstellung eines Chipkondensators nach Anspruch 5, dadurch gekennzeichnet, daß der Hüllrahmen (2) mit einem Abschnitt (18) verbunden wird, der von einem Bandsubstrat (16) hervorsteht, so daß gegenüberliegende Verlängerungen (21) des Abschnitts (18) in der obersten Oberfläche (24) des Hüllrahemens vertieft werden, und daß der Abschnitt (18) vom Bandsubstrat (16) getrennt wird, um als die lötbare Metallplatte (10) zu arbeiten.

7. Ein Verfahren nach Anspruch 6, dadurch gekennzeichnet, daß der Kondensator (1) in den Hohlraum (4) des Hüllrahmens (2) eingeführt wird, bevor der Abschnitt (18) vom Bandsubstrat (16) getrennt wird.

## Revendications

1. Condensateur de type puce comportant:
un condensateur (1) comportant des fils de connexion (3) se projetant depuis une borne d'extrémité de celui-ci; et
un motif de blindage (2) comportant une cavité (4) adaptée à la forme externe du condensateur (1) qui est logé dans la cavité (4), les fils de connexion (3) se projetant hors d'une première extrémité de la cavité et s'incurvant afin de reposer dans des gorges (6) situées sur la surface supérieure 24 du motif de blindage;
caractérisé en ce que:
la surface supérieure (24) du motif de blindage (2) est partiellement pourvue d'une couche métallique soudable (7, 8, 9, 10, 11) destinée à fixer le condensateur de type puce sur une carte de circuit, la couche métallique soudable étant espacée des fils de connexion (3); et
la première extrémité de la cavité (4) du motif de blindage (2) est partiellement fermée par un organe (5) qui définit une ouverture à travers laquelle les fils de connexion (3) se projettent avant de s'incurver pour reposer dans les gorges (6).

2. Condensateur de type puce selon la revendication 1, dans lequel les fils de connexion (3) s'étendent depuis une première extrémité de la surface supérieure (24) du motif de blindage (2) vers une seconde extrémité opposée de la surface supérieure, et la couche métallique soudable (7, 8, 9, 10, 11) est espacée de la première extrémité de la surface supérieure.

3. Condensateur de type puce selon la revendication 2, dans lequel la couche métallique soudable (7, 8, 9, 10, 11) est aménagée à la seconde extrémité de la surface supérieure (24) du motif de blindage (2).

4. Condensateur de type puce selon la revendication 2 ou 3, dans lequel la couche métallique soudable (7, 8, 9, 10, 11) est aménagée au-delà des extrémités libres des fils de connexion (3).

5. Condensateur de type puce selon l'une quelconque des revendications 1 à 4, dans lequel la couche métallique soudable est un morceau de métal soudable (7), une colle conductrice soudable (8), une couche métallique soudable (9) appliquée par évaporation ou dépôt non-électrolytique, ou une plaque métallique soudable (10) pourvue d'extensions (21) qui sont enterrées afin d'être liées à la plaque (10) dans la matière du motif de blindage (2).

6. Processus de fabrication d'un condensateur de type puce selon la revendication 5, dans lequel le motif de blindage (2) est connecté à une partie (18) qui se projette depuis un substrat en bande (16) de telle sorte que les extensions opposées (21) de la partie (18) sont enterrées dans la surface supérieure (24) du motif de blindage, et la partie (18) est ensuite séparée du substrat en bande (16) afin de faire fonction de plaque métallique soudable (10).

7. Processus selon la revendication 6, dans lequel le condensateur (1) est introduit dans la cavité (4) du motif de blindage (2) avant que la partie (18) ne soit séparée du substrat en bande (16).
